# EUROPÄISCHE PATENTSCHRIFT

(11) **EP 4 144 190 B1**
(45) Veröffentlichungstag und Bekanntmachung des Hinweises auf die Patenterteilung: **08.04.2026**
(21) Anmeldenummer: 21722455.9
(22) Anmeldetag: 29.04.2021
(51) Int. Cl.: H05K 3/30, H05K 3/34, H05K 1/02

(54) **BARRIERE GEGEN VERSCHWIMMEN VON SMT-BAUTEILEN**
BARRIER PREVENTING THE FLOATING OF SMT COMPONENTS
BARRIÈRE CONTRE LE DÉCALAGE DES COMPOSANTS SMT

(30) Priorität: 30.04.2020 EP 20172361
(43) Veröffentlichungstag der Anmeldung: 08.03.2023
(73) Patentinhaber: ZKW Group GmbH, 3250 Wieselburg (AT)
(72) Erfinder: HAIDEN, Christoph, 2630 Ternitz (AT); SPITZER, Johannes, 2514 Möllersdorf (AT); RAINER, Christoph, 2870 Aspang (AT)
(74) Vertreter: Patentanwaltskanzlei Matschnig & Forsthuber OG
(86) Internationale Anmeldenummer: PCT/EP2021/061288
(87) Internationale Veröffentlichungsnummer: WO 2021/219800

(56) Entgegenhaltungen:
- EP-A1- 0 817 550
- GB-A- 2 304 999
- US-A1- 2019 320 561

## Beschreibung

Die Erfindung betrifft ein Verfahren zum positionsstabilen Verlöten eines SMD-Bauteils mit einem Schaltungsträger.

Weiters betrifft die Erfindung einen Schaltungsträger hergestellt nach dem erfindungsgemäßen Verfahren. Ferner kann die Erfindung ebenso einen Kraftfahrzeugscheinwerfer und/oder ein Steuergerät umfassend einen erfindungsgemäßen Schaltungsträger betreffen.

Aus dem Stand der Technik sind bereits Verfahren bekannt geworden, die das positionsstabile Verlöten von SMD-Bauteilen ermöglichen sollen. Beispielsweise ist aus der AT 515071 A1 ein Verfahren bekannt geworden, in dem ein zu verlötendes elektronisches Bauteil mittels Klebepunkten an einem Schaltungsträger fixiert wird, wobei die Klebepunkte gehärtet werden, bevor ein Lötvorgang gestartet wird, um auf diese Weise ein Verschwimmen der Bauteile zu verhindern.

Grundsätzlich ist bekannt, dass sich das Volumen von Lötgut während des Lötvorganges durch Ausgasen von Flussmitteln reduziert. Diese Reduktion kann beispielsweise bis zu 50 % betragen. Wird ein elektronisches Bauteil daher in seiner Position festgeklebt, so muss sichergestellt werden, dass ein ausreichender Überschuss an Lötgut vorhanden ist, um trotz Schrumpfung des Lötguts sicherzustellen, dass eine ausreichende Menge an Lötgut an der Lötstelle vorhanden ist. Wird wie in der AT 515071 A1 das zu lötende Bauteil bereits vor dem Lötvorgang in seiner Position fixiert, so wird die Abnahme des Volumens des Lötgutes durch "überdrucken" kompensiert. Darunter versteht man das Anbringen von überschüssigem Lötgut in Bereichen, die über die eigentliche Kontaktstelle hinausgehen, um zu ermöglichen, dass dieses überschüssige Lötgut bei dem Schmelzvorgang der eigentlichen Kontaktstelle zufließt. Anderenfalls könnte eine Lötverbindung mangelhaft sein, in dem größere Lufteinschlüsse vorhanden sind, oder mangels Lötmaterials eine vollflächige durchgängige Kontaktierung nicht möglich sein. GB 2 304 999 A offenbart ein Verfahren zum Verlöten eines SMD-Bauteils auf einem Schaltungsträger.

Es gibt allerdings Situationen, in denen ein solches Überdrucken nicht möglich ist, beispielsweise weil benachbarte Bauteile dieses Überdrucken verunmöglichen, oder weil bereits die Lötgutdepots auf einem Leiterplattenlayout fest vorgegeben sind und ein bestehendes Leiterplattenlayout nun lediglich mit einem anders dimensionierten elektronischen Bauteil bestückt werden soll, ohne dass Änderungen an dem Schaltungsträger oder den Lötgutdepots vorgenommen werden sollen. Gleichzeitig soll eine möglichst wirtschaftliche Herstellbarkeit gewährleistet bleiben.

Eine Aufgabe der Erfindung besteht daher darin, ein Verfahren zu schaffen, welches eine Lösung zu der oben genannten Problematik liefert. Diese Aufgabe wird mit einem Verfahren eingangs genannter Art gelöst, indem erfindungsgemäß die folgenden Schritte vorgesehen sind:
a) Bereitstellen eines Schaltungsträgers umfassend zumindest eine mit Lötpaste beschichtete Trägerplattenkontaktfläche, die zur elektrischen, thermischen und/oder mechanischen Kontaktierung von dem zu verbindenden SMD-Bauteil eingerichtet ist, wobei der Schaltungsträger zumindest im Bereich der Trägerplattenkontaktfläche mit einer Anzahl an nicht mit geschmolzenem Lotgut benetzbaren gefüllten Durchkontaktierungen (es kann sich dabei z.B. um elektrisches Isoliermaterial wie beispielsweise um Resin, also Epoxy, handeln, alternativ dazu sind aber auch elektrisch leitfähige Werkstoffe oder Kombinationen davon einsetzbar, wie z.B. ein mit Metallpartikeln gefülltes Epoxy mit erhöhter thermischer Leitfähigkeit, auch ist der Einsatz von mit Keramik gefüllten Epoxy denkbar) durchsetzt ist,
b) Aufbringen von zumindest einem Klebepunkt an dem Schaltungsträger dergestalt, dass dieser Klebepunkt die mit Lötpaste beschichtete Trägerplattenkontaktfläche an einem zumindest einer Seite der Lötpaste zugeordneten Randpunkt begrenzt,
c) Aufsetzen eines zumindest eine Bauteilkontaktfläche umfassenden SMD-Bauteils auf die mit Lötpaste beschichtete Trägerplattenkontaktfläche dergestalt, dass die zumindest eine Bauteilkontaktfläche die Trägerplattenkontaktfläche über die dazwischenliegende Lötpaste elektrisch, thermisch und/oder mechanisch kontaktiert, wobei das Aufsetzen dergestalt erfolgt und die Position des zumindest einen Klebepunkts in Schritt b) dergestalt gewählt ist, dass das SMD-Bauteil berührungsfrei mit dem zumindest einen Klebepunkt auf der Lötpaste ruht,
d) Abwarten eines Aushärtevorgangs des zumindest einen Klebepunkts für eine vorgebbare Zeitdauer t, gegebenenfalls bei einer vorgebbaren Temperatur T,
e) Erhitzen, Schmelzen und nachfolgendes Abkühlen der Lötpaste zum Herstellen einer elektrischen, thermischen und/oder mechanischen Verbindung zwischen der zumindest einen Bauteilkontaktfläche des SMD-Bauteils und der zumindest einen Trägerplattenkontaktfläche des Schaltungsträgers, wobei mit Hilfe des zumindest einen Klebepunkts eine Barriere dergestalt ausgebildet ist, dass zum Ersten ein vertikales Absinken des SMD-Bauteils im geschmolzenen Zustand der Lötpaste ermöglicht ist, und zum Zweiten ein horizontales Verschwimmen des SMD-Bauteils auf der geschmolzenen Lötpaste in Richtung der Barriere durch die Barriere mechanisch begrenzt wird, wobei zumindest ein Klebepunkt kugelkalottenförmig ausgebildet ist.

Durch das erfindungsgemäße Verfahren ist es möglich, die Position des SMD-Bauteils in einer horizontalen Ebene einerseits dauerhaft festzulegen und ein Verschwimmen des Bauteils zu verhindern, und gleichzeitig ein Absinken des Bauteils in Bezug auf den Schaltungsträger zu ermöglichen, und so eine homogene Lötstelle zu ermöglichen, die weitestgehend frei von Voids ist. Bei der vorliegenden Erfindung werden die Klebepunkte - im Gegensatz zur AT 515071 A1 - nicht zur absoluten Fixierung des SMD-Bauteils, sondern zur Begrenzung der Position bzw. der Beweglichkeit des Bauteils innerhalb einer horizontalen Ebene eingesetzt. Die Erfindung macht sich zudem die Erkenntnis zu Nutze, dass das Vorhandensein von Durchkontaktierungen (insbesondere das Vorhandensein asymmetrisch angeordneter Durchkontaktierungen in Bezug auf die zu verlötende Kontaktfläche), die mit Lötgut nicht benetzbar sind, das nachteilige Verschwimmen von SMD-Bauteilen während des Lötvorganges stark begünstigt bzw. das Ausmaß des Verschwimmens deutlich erhöht. In einigen Situationen ist zwar ein geringfügiges Einschwimmen tolerierbar, ein Verschwimmen in größerem Ausmaß allerdings problematisch. In diesem Dokument werden die Begriffe "Einschwimmen" und "Verschwimmen" wie folgt verstanden: Der Ausdruck "Einschwimmen" wird als Bewegung des Bauteils auf dem flüssigen Lot innerhalb eines unkritischen Bereichs aufgefasst, d.h. in einem Ausmaß, dass die Funktionalität der Lötverbindung nicht beeinträchtig und die Abweichung von der Sollposition klein genug ist, um keinen (Pseudo-)Fehler bei einer nachgelagerten AOI (automated optical inspection) auszulösen. Der Begriff "Verschwimmen" wird als eine Schwimmbewegung aufgefasst, die ein problematisches Ausmaß aufweist, sodass es z.B. zu einer möglichen Beeinträchtigung der Lötverbindung kommt und/oder die Abweichung von der Sollposition so groß ist, dass (Pseudo-)Fehler bei einer etwaigen AOI detektiert werden. Da das Setzen von Klebepunkten als Begrenzung mit einem technischen und ökonomischen Aufwand verbunden ist, sollen die Klebepunkte daher nur dort eingesetzt werden, wo deren Einsatz wirtschaftlich gerechtfertigt ist. Deshalb werden die Klebepunkte gezielt bei einem Bauteil eingesetzt, das von solchen Durchkontaktierungen betroffen ist. Als Durchkontaktierungen (auch Vias genannt) kommen dabei insbesondere Vias vom Typ 5 in Frage, bei der die Durchkontaktierung durch eine in der Trägerplatte eingebettete Kupferhülse ausgebildet ist, die beispielsweise mit Resin verfüllt wird. Die Wärmeleitung erfolgt dabei im Wesentlichen über die Kupferhülse. Aufgrund der Füllung kann kein Lot in das Via eindringen bzw. das Via kann nicht benetzt werden, weshalb während des Lötvorganges Kräfte auf das Bauteil wirken können, die ein Verschwimmen begünstigen. Dies trifft insbesondere bei asymmetrischer Anordnung der Vias in Bezug auf das zu verlötende Bauteil zu.

Der Ausdruck "horizontal" bedeutet dabei eine Orientierung, die parallel in Bezug auf ein durch die Trägerplattenkontaktfläche ausgebildete Ebene ausgebildet ist. Nach dem Schritt e) kann auch noch ein Schritt f) vorgesehen sein, der das Abkühlen und die Entnahme des bestückten Schaltungsträgers umfasst. Unter dem Ausdruck "SMD-Bauteil" wird jedes Bauteil verstanden, dass an der Oberfläche des Schaltungsträgers befestigt ist - d.h. keine "through hole"-Technologie anwendet. Die SMD-Bauteile können z.B. auch durch Top-Contact Bonding mit der Leiterplatte elektrisch verbunden sein.

Grundsätzlich ist zumindest ein Klebepunkt für die Ausbildung der Barriere vorgesehen. Dieser kann in Situationen ausreichen, in denen man z.B. feststellen kann, dass die Bauteile nur in eine Richtung rotieren oder driften. Hier genügt ein Klebepunkt, der entgegengesetzt zur Rotations- bzw. Driftrichtung des Bauteils wirkt. Für die restliche Positionierung können gegebenenfalls Bauteilpins sorgen. Natürlich können aber auch zwei oder mehr Klebepunkte vorgesehen sein. Die Anzahl der Klebepunkte kann frei gewählt werden. Sämtliche Merkmale, die in der vorliegenden Erfindung in Hinblick auf "den zumindest einen Klebepunkt" erwähnt sind, können - sofern nicht anders angegeben - ebenso auf zwei oder mehr Klebepunkte angewendet werden.

Bei den Durchkontaktierungen kann es sich z.B. um Typ 5 Vias bzw. Typ V-Vias handeln. Diese sind sehr häufig explizit im Bereich des Leiterplatten-Pads enthalten um den thermischen Widerstand zu minimieren. Insbesondere das Vorhandensein von in Bezug auf die Trägerplattenkontaktfläche asymmetrisch angeordneten Durchkontaktierungen begünstigt das Verschwimmen, weshalb sich das Vorsehen von Barrieren im Falle des Vorliegens solcher asymmetrisch angeordneten Durchkontaktierungen als besonders günstig erwiesen hat.

Insbesondere kann vorgesehen sein, dass die in Schritt a) mit Lötpaste beschichtete Trägerplattenkontaktfläche mit einer Lötstopplackschicht umgeben ist, wobei der zumindest eine Klebepunkt auf der Lötstopplackschicht und/oder auf einem nicht mit Lötpaste beschichteten Abschnitt der Trägerplattenkontaktfläche angeordnet ist. Der Kleber kann dazu eingerichtet sein, besonders gut auf der Lötstopplackschicht zu haften. Zudem ist auf diese Weise verhindert, dass der Kleber mit Lötgut in Kontakt kommt. Alternativ dazu kann - wie erwähnt - der Klebepunkt auch auf dem Pad (d.h. der Leiterplattenkontaktfläche) für sich genommen oder auf dem Pad und/oder der Lötstopplackschicht der Leiterplatte gleichzeitig angebracht werden. Auch eine Überlappung mit der Lötpaste auf dem Pad ist dabei - wenn auch nicht wünschenswert - unter Umständen tolerierbar.

Weiters kann vorgesehen sein, dass die Höhe des zumindest einen Klebepunkts zumindest 40%, vorzugsweise zumindest 60%, besonders bevorzugt zumindest 100% der Höhe eines durch die Lötpaste ausgebildeten Lötpastendepots im ungeschmolzenen Zustand beträgt, wobei die Barriere ausschließlich durch den zumindest einen Klebepunkt selbst ausgebildet wird. Auf diese Weise kann eine Begrenzung bereits durch die Klebepunkte selbst geschaffen werden, ohne dass zusätzliche Bauteile hierfür erforderlich sind. Die Höhe der Klebepunkte ist aber günstiger Weise so gewählt, dass das zu sichernde Bauteil im Falle eines Verschwimmens gegen den Klebepunkt stößt. Dabei kann berücksichtigt werden, dass durch den Lötprozess das Lot ca. 50% seines Volumens verliert. Bei Chip-Bauteilen, z.B. Ohm'schen Widerständen, kann die Paste zum Beispiel mit einer Höhe von 120µm gedruckt werden.

Zumindest ein Klebepunkt ist kugelkalottenförmig ausgebildet.

Diese Form kann einerseits durch die Oberflächenspannung des eingesetzten Klebers sowie auch durch das angewendete Verfahren bestimmt sein. Beispielsweise können sogenannte "Jet-Dispenser" verwendet werden. Ein solcher "Jet-Dispenser" gibt Klebepunkte ab, die durch Deformation des gejetteten Kleber-"Partikels" beim Auftreffen auf die Leiterplatte meist eine Form ähnlich einer Kugelkalotte aufweisen. Unter der Verwendung dieses Verfahrens ist es auch möglich, mittels dieser einzelnen Punkte eine andere Geometrie zu erzeugen, z.B. sogenannte Kleberaupen. Es gibt allerdings auch sog. volumetrische Dispenser, welche den Kleber kontinuierlich absondern. Diese können zum Erzeugen von Linien oder ähnlichen geometrischen Formen aus Kleber verwendet werden.

Weiters kann vorgesehen sein, dass zumindest ein erster Klebepunkt linienförmig zur Ausbildung einer linienförmigen Barriere erweitert ist. Damit sind sowohl Kleberaupen als auch Klebelinien inkludiert.

Insbesondere kann vorgesehen sein, dass zumindest ein zweiter Klebepunkt vorgesehen ist, der vorzugsweise den ersten Klebepunkt kontaktiert, wobei der zweite Klebepunkt linienförmig dergestalt ausgebildet ist, dass gemeinsam mit dem ersten Klebepunkt eine im Wesentlichen L- oder U-förmige, das SMD-Bauteil zumindest teilweise umschließende Kontur ausgebildet wird. Auf diese Weise kann das Verschwimmen der zu befestigenden Bauteile in eine weitere Richtung weitestgehend verhindert werden.

Weiters kann vorgesehen sein, dass die Höhe des zumindest einen Klebepunkts zumindest 50 Mikrometer, vorzugsweise zumindest 100 Mikrometer, beträgt.

Insbesondere kann vorgesehen sein, dass nach Schritt b) und vor Schritt d) zumindest ein Begrenzungskörper auf den zumindest einen Klebepunkt aufgesetzt wird, und die Barriere mit Hilfe des Begrenzungskörpers ausgebildet wird. Die Verwendung von Begrenzungskörpern ermöglicht ein näheres Heranrücken der Barriere an das zu befestigende SMD-Bauteil. Auch kann die geometrische Form des Begrenzungskörpers gezielt an die Form des SMD-Bauteils angepasst werden. Der Begrenzungskörper kann beispielsweise U-Förmig oder L-Förmig sein oder auch eine gerade Form haben. Es können dabei Formen aus Polymeren bzw. Kunststoff oder auch Keramik sowie Metalle verwendet werden. Der Einsatz einer Form bestehend aus Polymer oder Keramik hat wirtschaftliche Vorteile. Die Schmelztemperatur des eingesetzten Begrenzungskörpermaterials sollte oberhalb der maximalen Temperatur des Lötvorganges liegen und die Oberfläche muss derart gestaltet sein, dass der Kleber haften bleibt.

Weiters kann vorgesehen sein, dass der zumindest eine Klebepunkt aus wärmehärtenden Material besteht und das Aushärten des zumindest einen Klebepunktes gemäß Schritt d) durch Temperaturerhöhung des Schaltungsträgers mitsamt des zumindest einen Klebepunktes erfolgt, wobei dies beispielsweise im Zuge eines Reflow- Lötvorganges erfolgt, wobei die für die Wärmehärtung erforderliche Temperatur unterhalb der Schmelztemperatur des Lötmaterials liegt.

Insbesondere kann vorgesehen sein, dass das Klebematerial dergestalt gewählt ist, dass das Klebervolumen während der Aushärtung um maximal 10% abnimmt.

Weiters kann vorgesehen sein, dass das Klebematerial wärmehärtend ausgebildet ist und dergestalt gewählt ist, dass sich dieses unter Zufuhr von Wärme während des Aushärtens gemäß Schritt d) ausdehnt. Ein Vorteil bei einem sich ausdehnenden Material besteht darin, dass im Gegensatz zur Kugelkalotte die Höhe nicht mit niedriger Steigung kontinuierlich zunimmt, sondern die Form einer steileren Begrenzung aufweist, die ein Heraufrutschen eines Bauteils erschwert. Neben flüssigen Klebstoffen könnten auch andere Klebstoffe eingesetzt werden. Z.B. kann ein pastöses, dispensierbares Klebematerial verwendet werden, das folgende Eigenschaften aufweist: Hitzebeständigkeit, Zunahme des Volumens unter Wärmezufuhr, haftet auf dem Lötstopplack und härtet weitestgehend aus, bevor die Schmelztemperatur des Lots erreicht ist. Hier könnte z.B.: auch ein Schaum auf Polyurethanbasis oder Silikon verwendet werden. Die Idee dabei ist, dass sich der dispensierte Punkt aus so einem Material beim Aufheizen ausdehnt und somit eine Barriere bildet, die sich auch seitlich sowie nach oben hin verbreitert, wodurch das Bauteil diese Form der Barriere wesentlich schwieriger überwinden kann, als einen Klebepunkt, welcher üblicherweise bis zur maximalen Höhe einen weitestgehend kontinuierlichen Anstieg aufweist.

Insbesondere kann vorgesehen sein, dass der zumindest eine Klebepunkt mittels eines Dispensers und das SMD-Bauteil mittels eines Bestückungsautomaten aufgebracht werden, wobei der zumindest eine Klebepunkt in Schritt b) dergestalt positioniert wird, dass dieser zumindest einen Sicherheitsabstand zu dem Randbereich der Sollposition des SMD-Bauteils aufweist, wobei dieser Sicherheitsabstand aus der Summe der Positionierungstoleranzen des Dispensers und des Bestückungsautomaten, der Größentoleranz des zumindest einen Klebepunkts sowie der Bauteiltoleranz des SMD-Bauteils gebildet wird und beispielsweise mindestens 50 Mikrometer beträgt. Derzeit beträgt der Sicherheitsabstand des Klebepunktes zu einem SMD-Bauteil mindestens 50 Mikrometer, und z.B. max. 300 Mikrometer. Wie erwähnt, sollten Bauteiltoleranzen mitberücksichtigt werden, d.h. nicht jedes Bauteil ist gleich groß. Z.B. können +/- 0,1 mm Unterschied der Bauteilgröße zu den Herstellerangaben möglich sein.

Weiters kann vorgesehen sein, dass das SMD-Bauteil eine rechteckige Grundfläche aufweist und der zumindest eine Klebepunkt so positioniert wird, dass der zumindest eine Klebepunkt nach Bestückung mit dem SMD-Bauteil unter Einhaltung des Sicherheitsabstandes in Schritt b) in unmittelbarer Nähe zu einer Seite der rechteckigen Grundfläche liegt. Der Ausdruck "in unmittelbarer Nähe zu einer Seite" bedeutet dabei, dass lediglich der Mindestabstand, z.B. 50 Mikrometer, vorgesehen ist. Auch könnte der Abstand in Bezug zu einer Ecke einer rechteckigen Grundfläche gewählt werden. Die Anzahl der Klebepunkte kann dergestalt gewählt werden, dass jeder Seite und/oder Ecke des SMD-Bauteils genau ein Klebepunkt zugeordnet ist. Damit ist ein Verschwimmen des Bauteils in alle Richtungen begrenzt. Unter dem Ausdruck "rechteckige Grundfläche" ist dabei nicht zwingend eine exakt rechteckige Form zu verstehen - natürlich können Ecken abgeflacht oder abgerundet sein oder Bauteilpins über diese Grundfläche hinaus reichen (das trifft z.B. auf eine LFPAK/SOT669-Bauform zu).

Weiters betrifft die Erfindung einen Schaltungsträger hergestellt nach dem erfindungsgemäßen Verfahren. Ferner kann die Erfindung ebenso einen Kraftfahrzeugscheinwerfer umfassend einen erfindungsgemäßen Schaltungsträger betreffen.

Anders ausgedrückt kann die Erfindung auch wie folgt beschreiben werden:
Bestimmte SMT Bauformen wie Powerflat 5x6 oder LFPAK/SOT669, aber auch TO-277A, besitzen auf einer Seite einzelne kleine Bauteilpins (bzw. Anschlusspins; z.B. N-Kanal MOSFET: Gate und Source), während der Großteil der Packageunterseite aus einem großen, zumeist durchgehenden Thermal Pad besteht (Bsp. N-Kanal MOSFET: Drain). Die Bauteile werden typischerweise sehr präzise auf die Lotpastendepots bestückt (<50µm Genauigkeit), aber aufgrund Faktoren wie suboptimale Footprintabmessungen, Via-Technologie oder Finish kann es passieren, dass diese Bauteile mit dem Thermal Pad während des Reflowprozesses verschwimmen, d.h., dass die Überlappung zwischen Bauteilpads und Leiterplattenpads nicht mehr ideal gegeben ist. Das führt häufig zu Fehlerkennungen (hier spricht man von Pseudofehlern. Das Bauteil ist (meist) funktionstüchtig, aber die Abweichung der Position ist größer als für die AOI zulässig) bei der automatischen optischen Leiterplatteninspektion (AOI), da das Bauteil mehr als die erlaubte Toleranz von seiner Position abweicht, aber auch im schlimmsten Fall zu schlecht ausgebildeten Lötstellen. Eine einfache Lösung, die grundsätzlich schon lange Industriestandard ist, wäre das Ankleben mit SMT-Kleber, etwa an 2 oder 4 Punkten entlang der Gehäusekante, damit das Bauteil beim Reflow nicht verschwimmt. Direktes Ankleben des Bauteils funktioniert folgendermaßen: Es werden die Pastendepots gedruckt, dann werden die Klebepunkte so neben die Pastendepots aufgebracht, dass beim darauffolgenden Bestücken des Bauteils z.B. dessen Kanten im Kleber zu liegen kommen. Wenn anschließend die bestückte Baugruppe in den Reflow-Ofen einfährt, wird als Erstes der Kleber aushärten, üblicherweise lange bevor die Lotpaste schmilzt. Dadurch wird das Bauteil in seiner sehr genauen Bestückposition gehalten und kann nicht mehr auf dem flüssigen Lot verschwimmen. Der Nachteil dieser bereits bekannten Methode ist allerdings die erforderliche Lotmenge für den entstehenden Lotspalt: Wenn ein kleines Bauteil auf die Paste bestückt wird (mit einer üblichen Kraft von 2-6N), wird es leicht in das Pastendepot gedrückt und liegt z.B. in einer Höhe von 50-100µm; bei größeren Bauteilen wie hier wird die Paste entsprechend weniger zusammengedrückt und das Bauteil liegt in einer Höhe im Bereich der Schablonendicke (100µm-150µm). Beim Reflow schmilzt die Lotpaste und verliert ca. 50% an Volumen, da nur der Zinnanteil in der Lötstelle verbleibt. Ohne Klebefixierung wird das Bauteil - wie bereits eingangs erwähnt - von der Ausgangshöhe nach unten sinken und es wird sich ein viel niedrigerer Lotspalt einstellen. Durch eine Klebefixierung des Bauteils müsste sich bei gleicher Pastenmenge die Verlötung reduzieren - z.B. in eine laterale Richtung. Das wurde bisher ausgeglichen, indem mehr Paste seitlich neben dem Pad gedruckt wird und das geschmolzene Lot beim Reflow über Einlaufschleusen unter das Bauteil einfließt (siehe z.B. EP 323 3345 A1). Für Bauformen mit relativ großen mit Lötpaste beschichteten Trägerplattenkontaktflächen und damit auch Lotpastensegmentierung (notwendig für Ausgasen von Flussmittel beim Löten) war daher relativ viel seitlicher Überdruck notwendig. Alle diese Vorkehrungen mussten bereits beim Leiterplattendesign getroffen werden und konnten nicht mehr im späteren Verlauf des Produktlebenszyklus ohne aufwändigen Change-Prozess oder Neuvalidierung (z.B. wg. Änderung der Lotspalthöhe) durchgeführt werden.

Die Erfindung stellt nun eine Abkehr von der Klebefixierung der SMD-Bauteile dar, und ermöglicht es, Barrieren auf der Leiterplatte zu erstellen, die das Verschwimmen während des Lötvorgangs von bestimmten darin oder daneben platzierten Bauteilen verhindern. Weiters sollen die Bauteile beim Auftragen des Klebers nicht damit in Berührung kommen, also somit auch einen Lotspalt ausbilden, als ob sie nicht geklebt wären. Im Gegensatz zum Stand der Technik wird hier das Verschwimmen von Bauteilen während des Lötvorgangs nicht durch direktes Ankleben verhindert, sondern dadurch, dass positions- und formstabile Klebepunkte oder darauf bestückte Elemente knapp neben dem Bauteil als Verschwimm-Barriere während des Reflow wirken.

Der folgende Ablauf kann sich während dem SMT-Fertigungsprozess ergeben:
- Nach dem Pastendruck werden SMT-Klebepunkte knapp neben dem fiktiven Bauteilrand platziert,
- Dann wird das Bauteil mit dem Bestückautomaten bestückt, ohne den Kleber zu berühren,
- Je nach Ausführung gibt es dann zwei Möglichkeiten
   ∘ Variante A: Klebepunkte selbst bilden später die Barriere; damit wäre der Bestückvorgang abgeschlossen
   ∘ Variante B: ein extra Barriere-Element wird in diesem Schritt neben dem Bauteil auf den Klebepunkt bestückt
- Klebepunkte härten im Reflow-Ofen rasch aus und bleiben an ihrer Position, erst dann beginnt das Lot unter dem Bauteil zu schmelzen
- Das Bauteil beginnt auf dem flüssigen Lot einzuschwimmen, ein Verschwimmen wird jedoch von dem bereits harten Klebepunkt (Var. A) oder dem mittels Kleber fixierten Barriere-Element (Var. B) (weitestgehend) verhindert.
- Es ergibt sich ein viel geringerer Versatz des Bauteils als ohne Barriere

Während die Bauteile ungehindert mehrere 100µm verschwimmen könnten (und dadurch außerhalb der zulässigen AOI-Toleranzen liegen würden) kann mit der gegenständlichen Methode das Verschwimmen auf ein vertretbares Ausmaß reduziert werden (beispielsweise 100-200µm).

Die Erfindung ist im Folgenden anhand einer beispielhaften und nicht einschränkenden Ausführungsform näher erläutert, die in den Figuren veranschaulicht ist. Darin zeigt
- Figur 1a: eine schematische Darstellung eines Ausschnitts eine Schaltungsträgers mit einem darauf zu befestigenden SMD-Bauteil gemäß dem Stand der Technik,
- Figur 1b: ein verschwommenes befestigtes SMD-Bauteil gemäß Fig. 1a,
- Figur 2a: eine Schnittdarstellung einer Ausführungsform gemäß der Erfindung im nichtverlöteten Zustand,
- Figur 2b: die Schnittdarstellung nach Fig. 2a im verlöteten Zustand,
- Figur 2c: ein Detail der Fig. 2b,
- Figur 2d: ein weiteres Detail der Fig. 2b, in dem erkennbar ist, dass das SMD-Bauteil gegen eine Barriere stößt und durch diese in seiner Position gehalten wird
- Figuren 3a bis 3d: Darstellung unterschiedlicher Varianten an Klebepunktkonfigurationen gemäß der Erfindung, und
- Figuren 4a bis 4c: unterschiedlicheVarianter an Begrenzungskörperkonfigurationen**,** die nicht zur Erfindung gehören.

In den folgenden Figuren bezeichnen - sofern nicht anders angegeben - gleiche Bezugszeichen gleiche Merkmale.

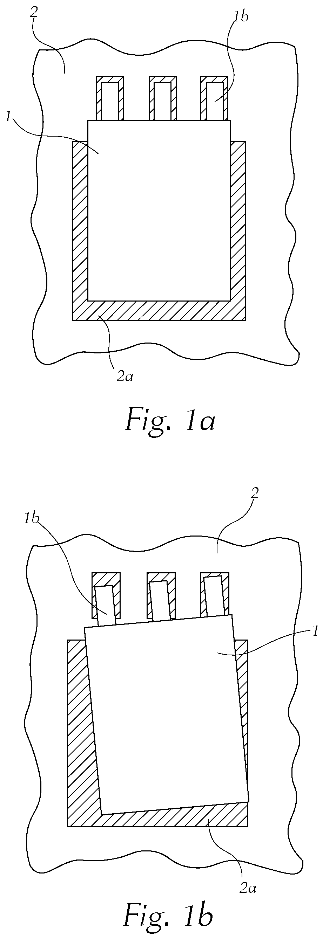

Figur 1a zeigt eine schematische Darstellung eines Ausschnitts eines Schaltungsträgers 2 mit einem darauf zu befestigenden SMD-Bauteil 1 gemäß dem Stand der Technik. Wie in Fig. 1b zu erkennen ist, ist das Bauteil 1 während des Lötvorganges auf einem in der Figur nicht dargestellten Lötdepot 3 verschwommen und in dieser verschwommenen Endposition fest verlötet.

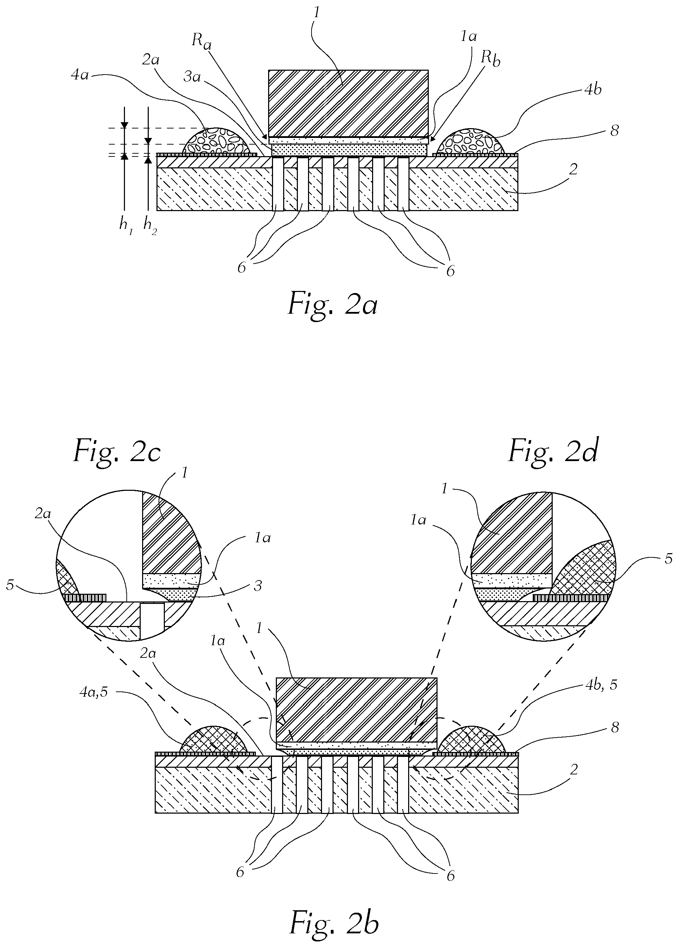

Figur 2a zeigt eine Schnittdarstellung einer Ausführungsform gemäß der Erfindung im nichtverlöteten Zustand. Darin ist eine Anordnung gezeigt, an der das erfindungsgemäße Verfahren durchgeführt wird. Die Erfindung betrifft ein Verfahren zum positionsstabilen Verlöten eines SMD-Bauteils 1 mit einem Schaltungsträger 2 und umfasst im gezeigten Ausführungsbespiel die folgenden Schritte a) bis e):
a) Bereitstellen eines Schaltungsträgers 2 umfassend zumindest eine mit Lötpaste 3 beschichtete Trägerplattenkontaktfläche 2a, die zur elektrischen, thermischen und/oder mechanischen Kontaktierung von dem zu verbindenden SMD-Bauteil 1 eingerichtet ist. Der Schaltungsträger 2 ist zumindest im Bereich der Trägerplattenkontaktfläche 2a mit einer Anzahl an nicht mit geschmolzenem Lotgut benetzbaren gefüllten Durchkontaktierungen 6 durchsetzt. Diese Anzahl ist grundsätzlich variabel und nicht auf einen bestimmten Wert beschränkt.
b) Aufbringen von - in diesem Ausführungsbeispiel - zwei Klebepunkten 4a und 4b an dem Schaltungsträger 2 dergestalt, dass diese Klebepunkte 4a und 4b die mit Lötpaste 3 beschichtete Trägerplattenkontaktfläche 2a an je einer Seite der Lötpaste 3 zugeordneten Randpunkten Rₐ bzw. R_{b} begrenzen. Unter einem Randpunkt wird dabei ein Punkt verstanden, der einer Seite der Lötpaste 3 bzw. einer darüber liegenden Seite des SMD-Bauteils 1 zugeordnet ist. Unter dem Ausdruck "begrenzen" wird dabei ein "Eingrenzen" verstanden. Das bedeutet nicht, dass der Randpunkt durch den Klebepunkt 4a bzw. 4b während des Aufbringens kontaktiert wird. Im Gegenteil - es ist ein Mindestabstand in Bezug auf das SMD-Bauteil 1 vorgesehen, wie noch später erwähnt wird. Der Ausdruck "begrenzen" stellt auf die Begrenzung eines Verschwimmvorganges des SMD-Bauteils 1 ab und die Randpunkte, insbesondere Ra und Rb, bezeichnen jeweils einen Punkt an exponierte Kanten bzw. Vorsprüngen des Bauteils 1, der beispielsweise bei einem Verschwimmvorgang auf eine Barriere 5 bzw. einen Klebepunkt 4a bzw. 4b stößt.
c) Aufsetzen eines zumindest eine Bauteilkontaktfläche 1a umfassenden SMD-Bauteils 1 auf die mit Lötpaste 3 beschichtete Trägerplattenkontaktfläche 2a dergestalt, dass die zumindest eine Bauteilkontaktfläche 1a die Trägerplattenkontaktfläche 2a über die dazwischenliegende Lötpaste 3 elektrisch, thermisch und/oder mechanisch kontaktiert. Das Aufsetzen erfolgt dabei dergestalt und die Position der Klebepunkte 4a und 4b in Schritt b) ist dergestalt gewählt, dass das SMD-Bauteil 1 berührungsfrei mit den Klebepunkten 4a und 4b auf der Lötpaste 3 ruht.
d) Abwarten eines Aushärtevorgangs der zwei Klebepunkte 4a und 4b für eine vorgebbare Zeitdauer t, beispielsweise eine Minute (genauer gesagt, kann dieser Vorgang je nach Temperatur z.B. bis 1-5min dauern - im typ. Reflow bei ~150°C Plateauphase am Anfang wird dieser Vorgang ca. 90-120s dauern),
e) Erhitzen, Schmelzen und nachfolgendes Abkühlen der Lötpaste 3 zum Herstellen einer elektrischen, thermischen und/oder mechanischen Verbindung zwischen der zumindest einen Bauteilkontaktfläche 1a des SMD-Bauteils 1 und der zumindest einen Trägerplattenkontaktfläche 2a des Schaltungsträgers 2. Mit Hilfe der Klebepunkte 4a und 4b, die in Figur 2b im bereits ausgehärteten Zustand gezeigt sind, wird eine Barriere 5 dergestalt ausgebildet, dass zum Ersten ein vertikales Absinken des SMD-Bauteils im geschmolzenen Zustand der Lötpaste 3 ermöglicht ist, und zum Zweiten ein horizontales Verschwimmen des SMD-Bauteils auf der geschmolzenen Lötpaste 3 in Richtung der Barriere 5 durch die Barriere 5 mechanisch begrenzt wird. Die Barriere 5 wird vorliegend durch die beiden Klebepunkte 4a und 4b gemeinsam ausgebildet.

Fig. 2c zeigt ein Detail der Fig. 2b. Darin ist erkennbar, wie sich das nun verfestigte Lötgut 3 in seiner Verteilung durch Einfluss der Durchkontaktierung 6 verändert hat: Dadurch, dass die Durchkontaktierung ebenso im Randbereich der Kontaktierung des SMD-Bauteils 1 liegt, und die Durchkontaktierung nicht mit Lötgut 3 benetzbar ist, hat sich das Lötgut 3 auf einen unterhalb des SMD-Bauteils 1 liegenden Bereich zurückgezogen. Dieses "Zurückziehen" verursacht mechanische Kräfte auf das SMD-Bauteil 1, die ein Verschwimmen des Bauteils 1 begünstigen. Das Verschwimmen tritt nicht immer ein - im vorliegenden Fall ist das Bauteil 1 allerdings nicht in seiner Position geblieben. Fig. 2d zeigt hingegen ein Szenario, in der das Bauteil 1 gegen die Barriere 5 stößt und durch diese in seiner Position gehalten wird.

In Figuren 2a und 2b ist erkennbar, dass die in Schritt a) mit Lötpaste 3 beschichtete Trägerplattenkontaktfläche 2a mit einer Lötstopplackschicht 8 umgeben ist, wobei die zwei Klebepunkte 4a und 4b auf der Lötstopplackschicht 8 angeordnet sind. Die Klebepunkte müssen allerdings nicht zwingend auf der Leiterplattenschicht platziert werden, sondern können sich z.B. auch auf der Trägerplattenkontaktfläche 2a der Leiterplatte befinden.

Die Höhe h₁ (siehe Fig. 2a) der Klebepunkte 4a, 4b, 4c, 4d, 4e beträgt zumindest 40%, vorzugsweise zumindest 60%, besonders bevorzugt zumindest 100% der Höhe h₂ (siehe Fig. 2a) eines durch die Lötpaste 3 ausgebildeten Lötpastendepots 3a im ungeschmolzenen Zustand, wobei die Barriere 5 ausschließlich durch die Klebepunkte 4a und 4b selbst ausgebildet wird.

In den Figuren 2a und 2b ist erkennbar, dass die Klebepunkte 4a und 4b kugelkalottenförmig ausgebildet sind.

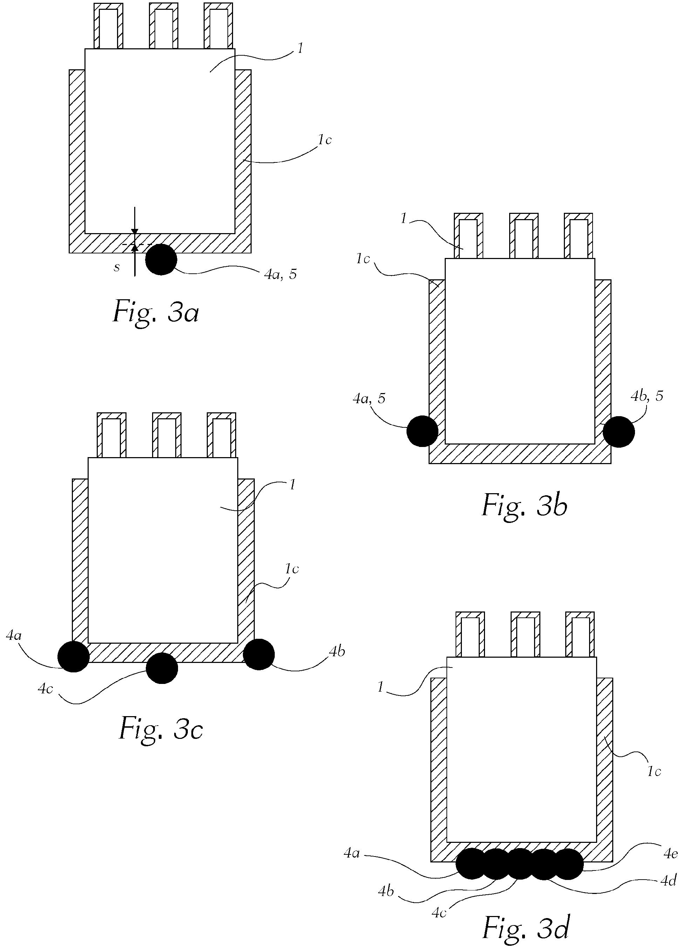

Figuren 3a bis 3d zeigen Darstellungen unterschiedlicher Varianten an Klebepunktkonfigurationen gemäß der Erfindung. In Fig. 3a ist die Verwendung eines einzigen Klebepunktes 4a gezeigt, der an einer Seite des SMD-Bauteils 1 positioniert ist. Fig. 3b zeigt eine Variante, bei der Klebepunkte 4a und 4b an je einer Ecke des SMD-Bauteils 1 positioniert sind. Fig. 3c zeigt eine Variante, in der zusätzlich zu den Eckklebepunkten 4a und 4b auch noch ein an der Seite angeordneten Klebepunkt 4c vorgesehen ist. Fig. 3d zeigt den Einsatz von fünf nacheinander angeordneten Klebepunkten 4a, 4b, 4c, 4d, 4e, die gemeinsam linienförmig zur Ausbildung einer linienförmigen Barriere 5 erweitert ist ("Kleberaupe"). Grundsätzlich sind noch zahlreiche weitere Konfigurationen denkbar. Beispielsweise kann vorgesehen sein, dass zumindest ein zweiter Klebepunkt vorgesehen ist, der vorzugsweise den ersten Klebepunkt kontaktiert, wobei der zweite Klebepunkt linienförmig dergestalt ausgebildet ist, dass gemeinsam mit dem ersten Klebepunkt eine im Wesentlichen L- oder U-förmige das SMD-Bauteil 1 zumindest teilweise umschließende Kontur ausgebildet wird.

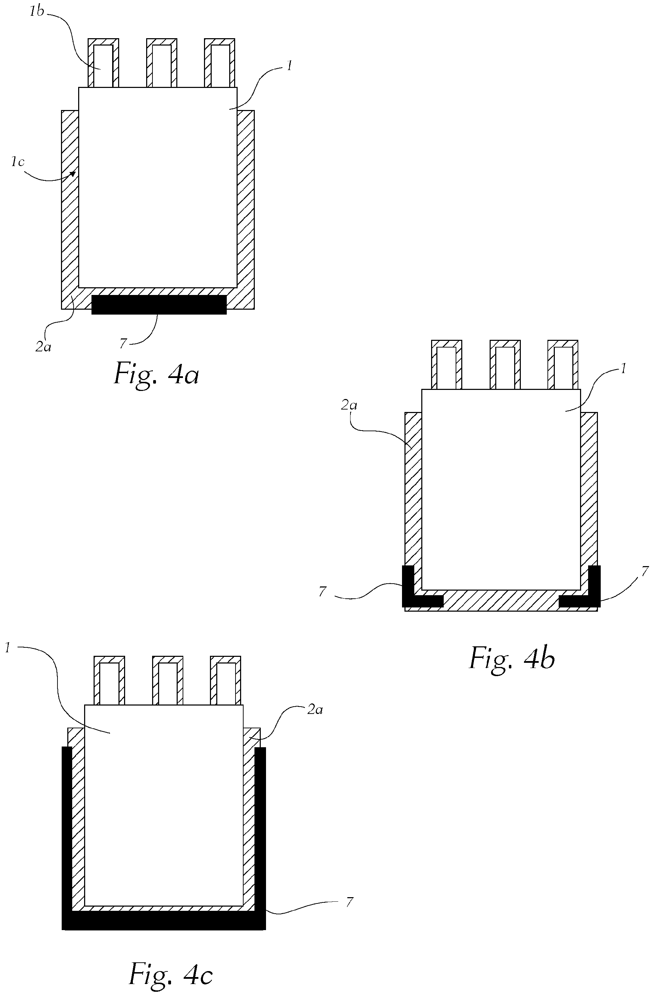

Die Figuren 4a bis 4c zeigen unterschiedliche Varianten an Begrenzungskörperkonfigurationen, die nicht zur Erfindung gehören. Demnach wird nach Schritt b) und vor Schritt d) zumindest ein Begrenzungskörper 7 auf den zumindest einen Klebepunkt 4a (in den Figuren nicht gezeigt) aufgesetzt. Die Barriere 5 ist mit Hilfe des Begrenzungskörpers 7 ausgebildet. Der Begrenzungskörper kann U-förmig (Fig. 4c) oder L-förmig (Fig. 4b) ausgebildet sein oder auch eine gerade Form (Fig. 4a) haben. Auch können mehrere Begrenzungskörper 7 eingesetzt werden.

Vorzugsweise bestehen die Klebepunkte aus wärmehärtendem Material. Die Wärmehärtetemperatur liegt dabei unterhalb der Schmelztemperatur des Lötguts.

In den Figuren 3a bis 4c ist erkennbar, dass das SMD-Bauteil 1 jeweils eine rechteckige Grundfläche 1c (Bezugszeichen siehe Fig. 3a und 4a) aufweist. Aus Fig. 3a geht hervor, dass der Klebepunkt 4a so positioniert wird, dass dieser nach Bestückung mit dem SMD-Bauteil 1 unter Einhaltung des Sicherheitsabstandes s in Schritt b) in unmittelbarer Nähe zu einer Seite der rechteckigen Grundfläche 1c liegt.

Die Erfindung ist nicht auf die gezeigten Ausführungsformen beschränkt, sondern durch den gesamten Schutzumfang der Ansprüche definiert.

Etwaige Bezugszeichen in den Ansprüchen sind beispielhaft und dienen nur der einfacheren Lesbarkeit der Ansprüche, ohne diese einzuschränken.

## Patentansprüche

1. Verfahren zum positionsstabilen Verlöten eines SMD-Bauteils (1) mit einem Schaltungsträger (2), umfassend die folgenden Schritte:
a) Bereitstellen eines Schaltungsträgers (2) umfassend zumindest eine mit Lötpaste (3) beschichtete Trägerplattenkontaktfläche (2a), die zur elektrischen, thermischen und/oder mechanischen Kontaktierung von dem zu verbindenden SMD-Bauteil (1) eingerichtet ist, wobei der Schaltungsträger (2) zumindest im Bereich der Trägerplattenkontaktfläche (2a) mit einer Anzahl an nicht mit geschmolzenem Lötgut benetzbaren gefüllten
Durchkontaktierungen (6) durchsetzt ist,
b) Aufbringen von zumindest einem Klebepunkt (4a, 4b, 4c, 4d, 4e) an dem Schaltungsträger (2) dergestalt, dass dieser Klebepunkt (4a, 4b, 4c, 4d, 4e) die mit Lötpaste (3) beschichtete Trägerplattenkontaktfläche (2a) an zumindest einer Seite der Lötpaste (3) zugeordneten Randpunkt (Rₐ, R_{b}) begrenzt,
c) Aufsetzen eines zumindest eine Bauteilkontaktfläche (1a) umfassenden SMD-Bauteils (1) auf die mit Lötpaste (3) beschichtete Trägerplattenkontaktfläche (2a) dergestalt, dass die zumindest eine Bauteilkontaktfläche (1a) die Trägerplattenkontaktfläche (2a) über die dazwischenliegende Lötpaste (3) elektrisch, thermisch und/oder mechanisch kontaktiert, wobei das Aufsetzen dergestalt erfolgt und die Position des zumindest einen Klebepunkts (4a, 4b, 4c, 4d, 4e) in Schritt b) dergestalt gewählt ist, dass das SMD-Bauteil (1) berührungsfrei mit dem zumindest einen Klebepunkt (4a, 4b, 4c, 4d, 4e) auf der Lötpaste (3) ruht,
d) Abwarten eines Aushärtevorgangs des zumindest einen Klebepunkts (4a, 4b, 4c, 4d, 4e) für eine vorgebbare Zeitdauer t,
e) Erhitzen, Schmelzen und nachfolgendes Abkühlen der Lötpaste (3) zum Herstellen einer elektrischen, thermischen und/oder mechanischen Verbindung zwischen der zumindest einen Bauteilkontaktfläche (1a) des SMD-Bauteils (1) und der zumindest einen Trägerplattenkontaktfläche (2a) des Schaltungsträgers (2), wobei mit Hilfe des zumindest einen Klebepunkts (4a, 4b, 4c, 4d, 4e) eine Barriere (5) dergestalt ausgebildet ist, dass zum Ersten ein vertikales Absinken des SMD-Bauteils im geschmolzenen Zustand der Lötpaste (3) ermöglicht ist, und zum Zweiten ein horizontales Verschwimmen des SMD-Bauteils auf der geschmolzenen Lötpaste (3) in Richtung der Barriere (5) durch die Barriere (5) mechanisch begrenzt wird, wobei zumindest ein Klebepunkt (4a, 4b, 4c, 4d, 4e) kugelkalottenförmig ausgebildet ist.

2. Verfahren nach Anspruch 1, wobei die in Schritt a) mit Lötpaste (3) beschichtete Trägerplattenkontaktfläche (2a) mit einer Lötstopplackschicht (8) umgeben ist, wobei der zumindest eine Klebepunkt (4a, 4b, 4c, 4d, 4e) auf der Lötstopplackschicht (8) und/oder auf einem nicht mit Lötpaste (3) beschichteten Abschnitt der Trägerplattenkontaktfläche (2a) angeordnet ist.

3. Verfahren nach Anspruch 1 oder 2, wobei die Höhe (h₁) des zumindest einen Klebepunkts (4a, 4b, 4c, 4d, 4e) zumindest 40%, vorzugsweise zumindest 60%, besonders bevorzugt zumindest 100% der Höhe (h₂) eines durch die Lötpaste (3) ausgebildeten Lötpastendepots (3a) im ungeschmolzenen Zustand beträgt, wobei die Barriere (5) ausschließlich durch den zumindest einen Klebepunkt (4a, 4b, 4c, 4d, 4e) selbst ausgebildet wird.

4. Verfahren nach einem der vorhergehenden Ansprüche, wobei die Höhe (h₁) des zumindest einen Klebepunkts (4a, 4b, 4c, 4d, 4e) zumindest 50 Mikrometer, vorzugsweise zumindest 100 Mikrometer, beträgt.

5. Verfahren nach Anspruch 1 oder 2, wobei nach Schritt b) und vor Schritt d) zumindest ein Begrenzungskörper (7) auf den zumindest einen Klebepunkt (4a) aufgesetzt wird, und die Barriere (5) mit Hilfe des Begrenzungskörpers (7) ausgebildet wird.

6. Verfahren nach einem der vorhergehenden Ansprüche, wobei der zumindest eine Klebepunkt (4a, 4b, 4c, 4d, 4e) aus wärmehärtenden Material besteht und das Aushärten des zumindest einen Klebepunktes (4a, 4b, 4c, 4d, 4e) gemäß Schritt d) durch Temperaturerhöhung des Schaltungsträgers (2) mitsamt des zumindest einen Klebepunktes (4a, 4b, 4c, 4d, 4e) erfolgt, wobei die beispielsweise im Zuge eines Reflow- Lötvorganges erfolgt, wobei die für die Wärmehärtung erforderliche Temperatur unterhalb der Schmelztemperatur des Lötmaterials liegt.

7. Verfahren nach einem der vorhergehenden Ansprüche, wobei das Klebematerial dergestalt gewählt ist, dass das Klebervolumen während der Aushärtung um maximal 10% abnimmt.

8. Verfahren nach einem der Ansprüche 1 bis 6, wobei das Klebematerial wärmehärtend ausgebildet ist und dergestalt gewählt ist, dass sich dieses unter Zufuhr von Wärme während des Aushärtens gemäß Schritt d) ausdehnt.

9. Verfahren nach einem der vorhergehenden Ansprüche, wobei der zumindest eine Klebepunkt (4a, 4b, 4c, 4d, 4e) mittels eines Dispensers und das SMD-Bauteil (1) mittels eines Bestückungsautomaten aufgebracht werden, wobei der zumindest eine Klebepunkt (4a, 4b, 4c, 4d, 4e) in Schritt b) dergestalt positioniert wird, dass dieser zumindest einen Sicherheitsabstand (s) zu dem Randbereich der Sollposition des SMD-Bauteils (1) aufweist, wobei dieser Sicherheitsabstand (s) aus der Summe der Positionierungstoleranzen des Dispensers und des Bestückungsautomaten, der Größentoleranz des zumindest einen Klebepunkts (4a, 4b, 4c, 4d, 4e) sowie der Bauteiltoleranz des SMD-Bauteils (1) gebildet wird und beispielsweise mindestens 50 Mikrometer beträgt.

10. Verfahren nach Anspruch 9, wobei das SMD-Bauteil (1) eine rechteckige Grundfläche (1c) aufweist und der zumindest eine Klebepunkt (4a, 4b, 4c, 4d, 4e) so positioniert wird, dass der zumindest eine Klebepunkt (4a, 4b, 4c, 4d, 4e) nach Bestückung mit dem SMD-Bauteil (1) unter Einhaltung des Sicherheitsabstandes (s) in Schritt b) in unmittelbarer Nähe zu einer Seite der rechteckigen Grundfläche (1c) liegt.

11. Verfahren nach einem der vorhergehenden Ansprüche, wobei in Schritt b) die Anzahl der Klebepunkte (4a, 4b, 4c, 4d, 4e) dergestalt gewählt wird, dass jeder Seite und/oder Ecke des SMD-Bauteils (1) genau ein Klebepunkt (4a, 4b, 4c, 4d, 4e) zugeordnet ist.

12. Schaltungsträger (1) hergestellt nach einem Verfahren gemäß einem der vorhergehenden Ansprüche.

## Claims

1. Method for positionally stable soldering of an SMD component (1) to a circuit carrier (2), comprising the following steps:
a) providing a circuit carrier (2) comprising at least one carrier plate contact surface (2a) coated with solder paste (3), which is designed for electrical, thermal, and/or mechanical contacting of the SMD component (1) to be connected, wherein the circuit carrier (2) is interspersed, at least in the area of the carrier plate contact surface (2a), with a number of filled through-plated holes (6) that cannot be wetted with molten solder,
b) Applying at least one adhesive dot (4a, 4b, 4c, 4d, 4e) to the circuit carrier (2) in such a way that this adhesive dot (4a, 4b, 4c, 4d, 4e) delimits the carrier plate contact surface (2a) coated with solder paste (3) at at least one edge point (Ra, Rb) associated with the solder paste (3),
c) Placing an SMD component (1) comprising at least one component contact surface (1a) onto the carrier plate contact surface (2a) coated with solder paste (3) in such a way that the at least one component contact surface (1a) is electrically, thermally, and/or mechanically contacted to the carrier plate contact surface (2a) via the solder paste (3) located between them (3) between them, the placement being carried out in such a way and the position of the at least one adhesive point (4a, 4b, 4c, 4d, 4e) in step b) being selected in such a way that the SMD component (1) rests on the solder paste (3) without contact with the at least one adhesive point (4a, 4b, 4c, 4d, 4e) on the solder paste (3), 4c, 4d, 4e) on the solder paste (3) without contact,
d) waiting for the at least one adhesive point (4a, 4b, 4c, 4d, 4e) to cure for a predeterminable period of time t,
e) heating, melting, and subsequent cooling of the solder paste (3) to produce an electrical, thermal, and/or mechanical connection between the at least one component contact surface (1a) of the SMD component (1) and the at least one carrier plate contact surface (2a) of the circuit carrier (2), wherein, with the aid of the at least one adhesive dot (4a, 4b, 4c, 4d, 4e) is used to form a barrier (5) in such a way that, firstly, vertical sinking of the SMD component is possible when the solder paste (3) is in a molten state and, secondly, horizontal blurring of the SMD component on the molten solder paste (3) in the direction of the barrier (5) is mechanically limited by the barrier (5), wherein at least one adhesive point (4a, 4b, 4c, 4d, 4e) is designed in the shape of a spherical cap.

2. Method according to claim 1, wherein the carrier plate contact surface (2a) coated with solder paste (3) in step a) is surrounded by a solder resist layer (8), wherein the at least one adhesive point (4a, 4b, 4c, 4d, 4e) is located on the solder resist layer (8) and/or on a section of the carrier plate contact surface (2a) that is not coated with solder paste (3).

3. Method according to claim 1 or 2, wherein the height (h1) of the at least one adhesive point (4a, 4b, 4c, 4d, 4e) is at least 40%, preferably at least 60%, and particularly preferably at least 100% of the height (h2) of a solder paste deposit (3a) formed by the solder paste (3) in the unmelted state, wherein the barrier (5) is formed exclusively by the at least one adhesive point (4a, 4b, 4c, 4d, 4e) itself.

4. Method according to one of the preceding claims, wherein the height (h1) of the at least one adhesive point (4a, 4b, 4c, 4d, 4e) is at least 50 micrometers, preferably at least 100 micrometers.

5. Method according to claim 1 or 2, wherein after step b) and before step d), at least one limiting body (7) is placed on the at least one adhesive point (4a), and the barrier (5) is formed with the aid of the limiting body (7).

6. Method according to one of the preceding claims, wherein the at least one adhesive point (4a, 4b, 4c, 4d, 4e) consists of thermosetting material and the curing of the at least one adhesive point (4a, 4b, 4c, 4d, 4e) according to step d) is carried out by increasing the temperature of the circuit carrier (2) together with the at least one adhesive point (4a, 4b, 4c, 4d, 4e), which is carried out, for example, in the course of a reflow soldering process, wherein the temperature required for heat curing is below the melting temperature of the soldering material.

7. Method according to one of the preceding claims, wherein the adhesive material is selected such that the adhesive volume decreases by a maximum of 10% during curing.

8. Method according to one of claims 1 to 6, wherein the adhesive material is thermosetting and is selected such that it expands during curing in accordance with step d) when heat is applied.

9. Method according to one of the preceding claims, wherein the at least one adhesive dot (4a, 4b, 4c, 4d, 4e) is applied by means of a dispenser and the SMD component (1) is applied by means of an automatic placement machine, wherein the at least one adhesive dot (4a, 4b, 4c, 4d, 4e) is positioned in step b) in such a way that it has at least one safety distance (s) to the edge area of the target position of the SMD component (1), wherein this safety distance (s) is formed from the sum of the positioning tolerances of the dispenser and the automatic placement machine, the size tolerance of the at least one adhesive dot (4a, 4b, 4c, 4d, 4e) and the component tolerance of the SMD component (1), and is, for example, at least 50 micrometers.

10. Method according to claim 9, wherein the SMD component (1) has a rectangular base area (1c) and the at least one adhesive point (4a, 4b, 4c, 4d, 4e) is positioned such that the at least one adhesive point (4a, 4b, 4c, 4d, 4e) is located in the immediate vicinity of one side of the rectangular base area (1c) after assembly with the SMD component (1), while maintaining the safety distance (s) in step b).

11. Method according to one of the preceding claims, wherein in step b) the number of adhesive dots (4a, 4b, 4c, 4d, 4e) is selected such that exactly one adhesive dot (4a, 4b, 4c, 4d, 4e) is assigned to each side and/or corner of the SMD component (1).

12. Circuit carrier (1) manufactured according to a method according to one of the preceding claims.

## Revendications

1. Procédé pour souder un composant SMD (1) avec un support de circuit (2) de manière à garantir la stabilité de sa position, comprenant les étapes suivantes :
a) mise à disposition d'un support de circuit (2) comprenant au moins une surface de contact de plaque de support (2a) recouverte de pâte à souder (3), qui est conçue pour établir un contact électrique, thermique et/ou mécanique avec le composant CMS (1) à assembler, le support de circuit (2) étant traversé, au moins dans la zone de la surface de contact (2a) de la plaque de support, par un certain nombre de trous métallisés remplis (6) qui ne peuvent pas être mouillés par la soudure fondue,
b) application d'au moins un point de colle (4a, 4b, 4c, 4d, 4e) sur le support de circuit (2) de telle sorte que ce point de colle (4a, 4b, 4c, 4d, 4e) délimite la surface de contact (2a) de la plaque support recouverte de pâte à souder (3) au moins sur un côté du point marginal (Ra, Rb) associé à la pâte à souder (3),
c) placement d'un composant SMD (1) comprenant au moins une surface de contact de composant (1a) sur la surface de contact (2a) de la plaque de support recouverte de pâte à souder (3) de telle sorte que la au moins une surface de contact de composant (1a) soit en contact électrique, thermique et/ou mécanique avec la surface de contact (2a) de la plaque de support via la pâte à souder intercalée (3) intermédiaire, la pose étant effectuée de telle sorte et la position du au moins un point de colle (4a, 4b, 4c, 4d, 4e) étant choisie à l'étape b) de telle sorte que le composant SMD (1) repose sans contact avec le au moins un point de colle (4a, 4b, 4c, 4d, 4e) repose sans contact sur la pâte à souder (3),
d) attente d'un processus de durcissement du au moins un point de collage (4a, 4b, 4c, 4d, 4e) pendant une durée t prédéfinie,
e) chauffage, fusion et refroidissement ultérieur de la pâte à souder (3) pour établir une connexion électrique, thermique et/ou mécanique entre la au moins une surface de contact (1a) du composant SMD (1) et la au moins une surface de contact (2a) du support de circuit (2), une barrière (5) étant conçue à l'aide d'au moins un point de colle (4a, 4b, 4c, 4d, 4e) est formée une barrière (5) de telle sorte que, d'une part, un enfoncement vertical du composant CMS à l'état fondu de la pâte à souder (3) est possible et que, d'autre part, un déplacement horizontal du composant CMS sur la pâte à souder fondue (3) en direction de la barrière (5) est limité mécaniquement par la barrière (5), au moins un point de collage (4a, 4b, 4c, 4d, 4e) étant réalisé en forme de calotte sphérique.

2. Procédé selon la revendication 1, dans lequel la surface de contact (2a) de la plaque de support recouverte de pâte à souder (3) à l'étape a) est entourée d'une couche de vernis épargne (8), le au moins un point de collage (4a, 4b, 4c, 4d, 4e) est disposé sur la couche de vernis épargne (8) et/ou sur une partie de la surface de contact de la plaque support (2a) non recouverte de pâte à souder (3).

3. Procédé selon la revendication 1 ou 2, dans lequel la hauteur (h1) d'au moins un point de collage (4a, 4b, 4c, 4d, 4e) est d'au moins 40 %, de préférence d'au moins 60 %, de manière particulièrement préférée d'au moins 100 % de la hauteur (h2) d'un dépôt de pâte à souder (3a) formé par la pâte à souder (3) à l'état non fondu, la barrière (5) étant formée exclusivement par le au moins un point de collage (4a, 4b, 4c, 4d, 4e) elle-même.

4. Procédé selon l'une des revendications précédentes, la hauteur (h1) du au moins un point de collage (4a, 4b, 4c, 4d, 4e) étant d'au moins 50 micromètres, de préférence d'au moins 100 micromètres.

5. Procédé selon la revendication 1 ou 2, dans lequel, après l'étape b) et avant l'étape d), au moins un corps de limitation (7) est placé sur le au moins un point de collage (4a) et la barrière (5) est formée à l'aide du corps de limitation (7).

6. Procédé selon l'une des revendications précédentes, dans lequel le au moins un point de colle (4a, 4b, 4c, 4d, 4e) est constitué d'un matériau thermodurcissable et le durcissement du au moins un point de colle (4a, 4b, 4c, 4d, 4e) conformément à l'étape d) s'effectue par augmentation de la température du support de circuit (2) avec le au moins un point de collage (4a, 4b, 4c, 4d, 4e), laquelle augmentation s'effectue par exemple au cours d'un processus de soudage par refusion, la température nécessaire au durcissement thermique étant inférieure à la température de fusion du matériau de soudage.

7. Procédé selon l'une des revendications précédentes, dans lequel le matériau adhésif est choisi de telle sorte que le volume de colle diminue de 10 % au maximum pendant le durcissement.

8. Procédé selon l'une des revendications 1 à 6, dans lequel le matériau adhésif est thermodurcissable et est choisi de telle sorte qu'il se dilate sous l'effet de la chaleur pendant le durcissement conformément à l'étape d).

9. Procédé selon l'une des revendications précédentes, dans lequel le ou les points de colle (4a, 4b, 4c, 4d, 4e) sont appliqués à l'aide d'un distributeur et le composant CMS (1) est appliqué à l'aide d'une machine de placement automatique, le ou les points de colle (4a, 4b, 4c, 4d, 4e) est positionné à l'étape b) de telle sorte qu'il présente au moins une distance de sécurité (s) par rapport à la zone périphérique de la position de consigne du composant CMS (1), cette distance de sécurité (s) étant formée à partir de la somme des tolérances de positionnement du distributeur et de la machine d'assemblage, de la tolérance dimensionnelle du au moins un point de colle (4a, 4b, 4c, 4d, 4e) et de la tolérance dimensionnelle du composant CMS (1), et qui est par exemple d'au moins 50 micromètres.

10. Procédé selon la revendication 9, dans lequel le composant SMD (1) présente une surface de base rectangulaire (1c) et le au moins un point de colle (4a, 4b, 4c, 4d, 4e) est positionné de telle sorte que le au moins un point de colle (4a, 4b, 4c, 4d, 4e) se trouve, après le montage du composant CMS (1), à proximité immédiate d'un côté de la surface de base rectangulaire (1c), en respectant la distance de sécurité (s) à l'étape b).

11. Procédé selon l'une des revendications précédentes, dans lequel, à l'étape b), le nombre de points de collage (4a, 4b, 4c, 4d, 4e) est choisi de telle sorte qu'exactement un point de collage (4a, 4b, 4c, 4d, 4e) soit attribué à chaque côté et/ou coin du composant CMS (1).

12. Support de circuit (1) fabriqué selon un procédé conforme à l'une des revendications précédentes.
